(19) Europäisches Patentamt

European Patent Office

Office européen des brevets

(11) Publication number: 0 649 147 A1

## (12) EUROPEAN PATENT APPLICATION

(21) Application number: 93402511.5

(22) Date of filing: 11.10.93

(51) Int. Cl.⁶: G11C 11/56

(43) Date of publication of application:
19.04.95 Bulletin 95/16

(84) Designated Contracting States:
AT BE CH DE DK ES FR GB GR IE IT LI LU MC
NL PT SE

(71) Applicant: TEXAS INSTRUMENTS FRANCE
B.P. 5
F-06270 Villeneuve Loubet (FR)

(84) FR

(71) Applicant: TEXAS INSTRUMENTS
INCORPORATED
13500 North Central Expressway

Dallas
Texas 75265 (US)

(84) BE CH DE DK ES GB GR IE IT LI LU MC NL PT
SE AT

(72) Inventor: D'Arrigo, Sebastiano
11 Avenue du Roi Albert
F-06400 Cannes (FR)

(74) Representative: Obolensky, Michel et al
c/o CABINET LAVOIX
2, place d'Estienne d'Orves
F-75441 Paris Cédex 09 (FR)

### (54) Increased capacity storage device.

(57) This storage device (70) includes at least one elementary memory cell (10), means (45,46,47,48) for writing a set of n bits of data into each said at least one elementary memory cell, and/or means (47,64,66,72) for reading a set of n bits of data from each said at least one elementary memory cell (10), with $n \geq 2$. Thus, the data bit storage capacity of the storage device (70) exceeds the number of elementary memory cells (10) contained in said storage device.

The writing of several bits into a single memory cell occurs by applying to said cell a threshold voltage which is representative of said several bits. The reading of the stored bits is performed by applying a plurality of successive voltages to the memory element and monitoring the event of a current flowing through a detector means (64).

FIG.6

The present invention relates to an elementary memory cell, a storage device including a plurality of such elementary memory cells, and a method for writing/reading information into/from said storage device and memory cell.

There is an ever increasing demand for improvements in the amount of information which can be stored in a memory, such as, for example, a non-volatile memory in the form of an electrically erasable programmable read only memory (EEPROM or $E^2$PROM) or an erasable programmable read only memory (EPROM).

Traditionally, this demand has been met by reducing the size of each memory cell, such that a greater number of cells can be located in a given area. Inevitably, this leads to the need to redesign cell layouts and the photolithography equipment, and to an ever increasing stretch on the capabilities of the machinery needed to reduce the size of the cells.

Therefore, there will eventually come a stage where further reduction of the size of the cell is no longer possible due to equipment constraints.

Object of the invention

It is therefore an object of the present invention to provide an elementary memory cell with improved storage capacity, capable of storing $n \geq 2$ data bits of information in each single memory cell, yet without need to further reduce the size of the elementary cell used.

It is a further object of the invention to provide a storage device using a plurality of such memory cells.

It is a further object of the invention to provide a method and the associated peripheral hardware, to write data into and/or read data from a memory cell or a storage device as defined above.

Summary of the invention

These objects are achieved by the memory cell and storage device according to the invention, and by the method for writing information into or read information from such a memory cell or storage device, as defined in the appending claims, which are summarized below :

The storage device using an array of memory elements, is characterized in that it includes means for writing a set of n bits of data into each said at least one elementary memory cell, and/or means for reading a set of n bits of data from each said at least one elementary memory cell, with $n \geq 2$, whereby the data bit storage capacity of said storage device exceeds the number of elementary memory cells contained in said storage device.

According to further features of the storage device :

- said means for writing a set of n bits of data into each said at least one elementary memory cell includes digital to analog converter means for converting respective sets of n-bit digital data into respective analog writing voltages Vpp, each said respective analog writing voltage Vpp being applied to a write control terminal of a respective elementary memory cell, and each said writing voltage Vpp being representative of a respective n-bit digital data set, whereby n bits of data are stored into each said respective elementary memory cell;

- it includes decoder means receiving n bits of D/A converter input data, said decoder means having its outputs connected to the inputs of said digital to analog converter means, such as to supply said inputs with 2n-bits of digital data to be converted to analog writing voltages Vpp;

- said means for reading a stored set of n bits of data from each said at least one elementary memory cell includes :

- means for generating a sequence of analog reading voltages Vr, said voltages being successively applied to a read control terminal of each said at least one elementary storage cell, causing a current to flow or not to flow accross each said elementary memory cell depending on the value of the respective set of n bits stored in the respective elementary memory cell, and on the value of the respective analog voltage Vr applied;

- for each elementary memory cell, sensing means connected to said elementary memory cell such as to detect, for each applied reading voltage Vr, the event of a current flowing or not flowing accross said elementary memory cell, said sensing means generating on its n latched ouputs a logical "1" or a logical "0" depending on the result of said detection;

- sequencing means for determining the order according to which said reading voltages Vr are to be applied to each elementary memory cell;

- said sensing means is comprised of a latched sense amplifier having its input connected to the read output of the associated elementary memory cell, and n latched outputs which are part of an n bit output data bus representative of the n bits of data previouly stored in each memory cell, whereby each sense amplifier output identifies the value ("0" or "1") of a respective bit of the set of n bits stored in the associated elementary memory cell;

- when a current flow is detected by said sense amplifier at a respective applied reading voltage, the value of the respective bit of said data set is a logic "1", and when no current flow is detected the value of the respective bit of said data set is a logic "0";
- each said elementary memory cell comprises a CMOS device having a writing/reading control gate to which the writing/reading voltages are applied, a drain and a source, the event of a current flow in the source being detected by said sensing means, whereby the detection of a current flow in said sensing means indicates that a logical "1" is read from the elementary memory element, and the detection of the absence of a current flow in a respective sensing means indicates that a logical "0" is read from the elementary memory element;
- said elementary memory cell is a non volatile memory element, in the form of a semiconductor device;
- said elementary memory cell is an EEPROM memory cell;
- said elementary memory element is an EPROM memory cell;
- the storage device includes a plurality of RxC elementary memory cells, arranged according to an array of R rows and C columns, where R and C are integers greater than one;
- N sense amplifiers are shared by a plurality of memory cells.

The invention also relates to a method of storing an n-bit data set, with $n \geq 2$, in an elementary memory cell, the method being characterized in that it includes the steps of :

- converting said n-bit data set into an analog voltage Vpp uniquely associated with said n-bit data set;
- applying said analog voltage Vpp to said memory cell, thereby producing in said memory cell a lasting threshold voltage Vth which is a function of the applied analog voltage, whereby the binary information corresponding to said n-bit data set is stored in said elementary memory cell. This method is extended according to the invention, to a method of storing an N-bit serial data set (where N > n) into a storage device having the above listed features and comprising a plurality of elementary memory cells, characterized in that it includes the steps of :
- partitioning said N-bit data stream into a plurality of n-bit data sets;
- storing each n-bit data set into a respective one of said elementary memory cells.

Finally, the invention relates to a method of reading from an elementary memory cell an n-bit data set stored therein in the form of a threshold voltage Vth indicative of said n-bit data set, characterized in that it includes the steps of :

- applying a first predetermined reading voltage Vr1 to said elementary memory cell;
- detecting at a detector means the presence or absence of a current flowing in response to said first reading voltage Vr1 and thereby identifying a first bit of said n-bit data set;
- applying a second predetermined reading voltage Vr2 to said elementary memory cell;
- detecting at said detector means the presence or absence of a current flowing in response to said second reading voltage Vr2 and thereby identifying a second bit of said n-bit data set;
- repeating the above two-step process with respective predetermined reading voltages Vri for i = 1 to n until all the n bits of the n-bit data set have been identified.

The invention extends to a method of reading an N-bit data stream (where N > n) from a storage device as defined above, where said storage device includes a plurality of elementary memory cells, characterized in that it includes the steps of :

- reading from each elementary memory cell, an n-bit data set, according to the above described reading method, whereby a plurality of n-bit data sets is obtained;
- assembling an N-bit data stream, based on said plurality of n-bit data sets.

Further objects, features and advantages of the invention will become apparent from the following description and the accompanying drawings, in which :

Figure 1 is a cross-sectional drawing for illustrating the "Fowler-Nordheim" mechanism for programming and reading a memory cell or elementary storage element;

Figure 2 is a schematic representation of a typical elementary storage element according to figure 1;

Figure 3 is a block diagram of a storage device according to the present invention for storing a digital data stream into the memory cell of Figure 2;

Figure 4 is a diagram of one embodiment of an analog to digital converter for use in the storage device according to figure 3;

Figure 5 is a block diagram of a system for reading digital information out of the memory cell of Figure 2;

Figure 6 is a schematic representation of a storage device including an array of elementary memory cells and means for writing/reading information into/from said memory cells.

There are a number of mechanisms by which a memory can be programmed (i.e written into), and read. Two typical mechanisms which are the most preferred are the so called "Hot electron" mechanism and the "Fowler-Nordheim" mechanism.

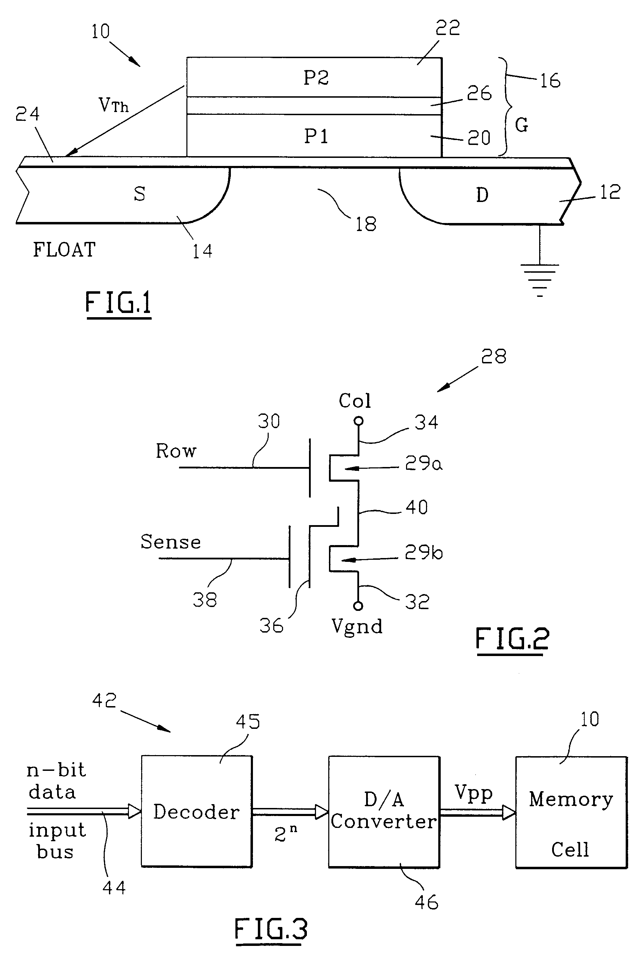

The "Fowler-Nordheim" (F-N) mechanism is now described below with reference to Figure 1.

A transistor-implemented memory cell is shown generally at 10. It includes a drain region 12, a source region 14 and a gate region 16 all located on a substrate 18 in the form of a channel. The gate region 16 is split into two parts, a gate region 20 (floating gate) and a gate region 22 (control gate). A gate oxide layer 24 exists between the source/drain and the P1 gate region 20, and an interleaved gate oxide layer 26 exists between the two gate regions 20,22. The drain 12 is typically maintained at 0V, the source 14 is at a floating voltage and the P2 doped part 22 of gate 16 is held at a high voltage, for instance at Vpp = 16 Volts.

The typical mode of operation of the above described transistor 10 as a memory cell, is as follows.

Each memory cell 10 is normally capable of storing one bit of information: a "1" or a "0". This bit of information can be written into the cell, by applying a high voltage or programming pulse, of about 16V, to the P2 gate region 22. This voltage causes electrons in the drain 12 (an N-diffusion region) to tunnel through oxide layer 24 into the P1 gate region 20, because the electric field has a strength of 7 to 8V/100 Å which is sufficient to start the tunnelling.

The electrons are then trapped in the P1 gate region 20, and the corresponding voltage represents one bit of stored information. As this mechanism does not rely on current flow for its implementation and is reversable, the mechanism is ideally suited for E$^2$PROMs. According to one frequently used convention, erasing a cell means programming a "1", and writing into a cell means programming a "0".

The presence of the electrons in the P1 gate region 20 produces a threshold voltage Vth in the memory cell 10. This threshold voltage is measured between the P2 control gate 22 and the source 14, and is defined as the voltage at which current begins to flow between the source 14 and the drain 12. This threshold voltage Vth is typically a proportional function of the programming pulse Vpp, and is given by the following relationship :

$$Vth = K1\ Vpp + K$$

where Vpp is the voltage of the programming pulse used for writing information into the memory cell (16V in this case), K is a constant voltage dependent on process parameters (or an intrinsic threshold voltage) and K1 is a coefficient relating the threshold voltage and the programming pulse. K1 is typically equal to one when the Vpp amplitudes are greater than the voltage required to initiate the F-N mechanism (i.e. >8-10V) and when the Vpp pulses are wider than a few milliseconds.

The use of typical memory cells 10 for the purpose of storing and retrieving information is as follows.

For a memory cell 10, the floating gate 20 is charged with electrons when a positive programming voltage is applied to gate 22, and the electrons in turn render the source-drain path or channel 18 under the charged floating gate 20 nonconductive or conductive, depending on the voltage, (typically a "wordline select" voltage of an array of memory cells), which is applied to the control gate 22. The nonconductive state of the channel 18 is read as a "zero" bit. The conductive state is read as a "one" bit.

The floating gate of a non-programmed cell is positively charged, is neutrally charged, or is slightly negatively charged, such that the channel 18 under a non-programmed floating gate 20 is conductive when the same chosen wordline select voltage is applied to the control gate.

Before programming the memory cell, the initial uniform threshold voltage Vto may be, for example, +2.5V between control gate 22 and source 14. Adjustment of the initial uniform threshold voltage Vto may be made by altering the doping level of the channel regions of the cells during manufacture.

In general, the level of channel doping, the programming pulse strength (writing a "0"), the erasing pulse strength (writing a "1") and other factors are chosen such that the source-drain path of a cell will either be conductive or non-conductive depending on the voltage applied to the control gate 22. The reading voltage which is applied to retrieve information from the memory cell must have a value somewhere between the highest threshold-voltage corresponding to the erased state of the cell, and the lowest threshold-voltage corresponding to the programmed state of a cell. In many types of memory arrays, the channel doping level, programming/erasing voltages and other cell parameters are chosen such that the wordline selection voltage is equal to the available chip supply voltage Vcc, which may be +5V. With +5V applied to the control gates 22, the source-drain paths of all the properly erased cells 10 are conductive only if those cells have threshold voltages Vth below the +5V reading voltage. Similarly, the source-drain

EP 0 649 147 A1

paths of all the properly programmed cells are non-conductive only if those cells have threshold voltages Vth greater than the +5V reading voltage.

The writing of a bit of information into a storage cell 10 has been described previously. This bit of information may be read from the cell by applying a reading voltage Vr of, for example, 2-3V across the memory cell, Vr having a value which is between the threshold voltages corresponding to a stored "1" and a stored "0". Accordingly, if there is a logic "1" stored in memory cell 10, the threshold voltage of the cell is low. If the applied reading voltage Vr does not cause a detectable current to flow, the stored bit must be a logic "0". On the other hand if a current is detected when the reading voltage Vr is applied, the threshold voltage must be less than the applied reading voltage Vr, and accordingly a logic "1" was stored in the memory cell.

As will now be described, according to the present invention, the above described elementary memory cell 10 can be used to store two or more bits of information in a single cell, rather than only one bit (a "0" or a "1") per cell, as known from the prior art.

Referring to Figure 2 a schematic representation 28 of transistors implementing the memory cell or storage element 10 according to Figure 1, is shown. The representation 28 includes a selection on transistor 29a including ROW/COLUMN selection terminals 30/34, and a storage transistor 29b. The latter includes four terminals 32, 36, 38, 40, corresponding to input/output and control lines of the memory cell 10 of Figure 1 : Vground 32 corresponds to Source 14, area 40 corresponds to Drain 12, SENSE terminal 38 corresponds to control gate 22, and floating gate 36 corresponds to gate region P1 (20) in Figure 1.

In order to write for example two bits of information into the elementary memory cell 10, the invention uses decoding means and digital to analog converting means, as described in relation with Figure 3.

Figure 3 is a block diagram of a storage device 42 which includes means necessary for programming or writing into the elementary memory cell 10. These means include a n-bit input bus 44 providing n-bit digital data set to an input decoder 45, where the n-bit data set to be stored in memory cell 10 is prepared and supplied to a digital to analog (D/A) converter 46. The latter provides on its analog output an analog voltage signal Vpp, the amplitude of which is indicative of the digital n-bit input. The voltage signal Vpp is supplied as an analog control signal to memory element 10, where it causes the analog storage of an n-bit digital value, in a way that will be explained later.

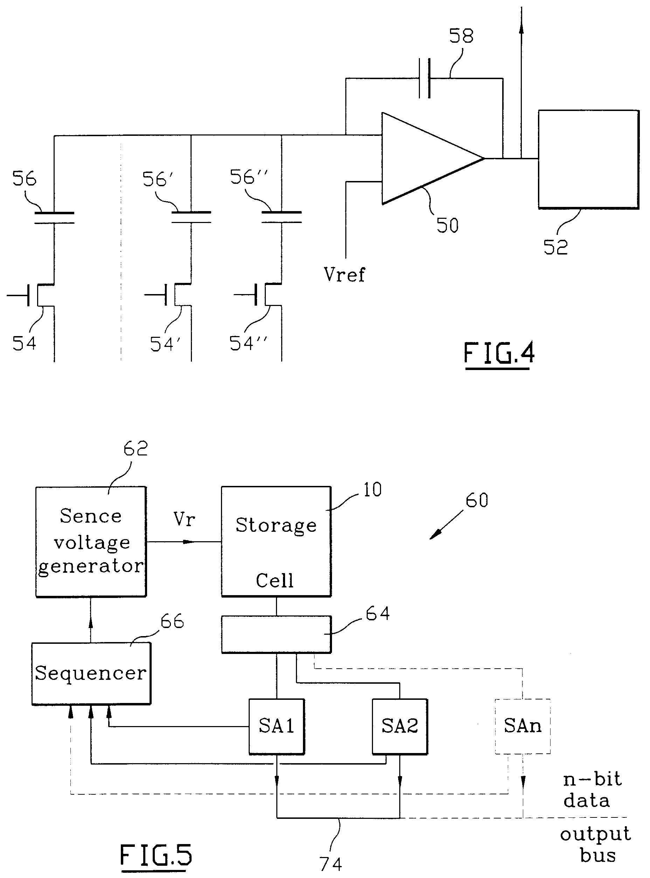

A possible implementation of the D/A converter 46 is shown in more detail in Figure 4. It includes an amplifier 50, a voltage multiplier 52 and a plurality of transistor elements 54, 54', 54'' with associated capacitors 56, 56', 56'' connected in series therewith. A feedback capacitor loop 58 is connected across the amplifier 50 as is typical in D/A processing.

The operation of the storage device 42 in programing or writing mode will now be described by way of example for the storage of a two-bit data string into cell 10, being understood that the invention can be generalized and that larger strings of digital information can be stored in a single memory cell, according to the present invention.

If a two bit data set is entered into decoder 44, the value of Vpp generated by the D/A converter 48 depends upon the value of the two bits. For example, if the two-bit set is "00", Vpp is not generated; if the two bits are "01", Vpp = 15V; if the two bits are "10", Vpp is 16V; and if the two bits are "11", Vpp is 17V. To each two-bit binary value to be stored in memory cell 10, corresponds a unique analog programming or writing voltage Vpp.

When applied to the elementary memory cell 10, the programming pulse Vpp will produce a given threshold voltage Vth across the memory cell, as previously explained in relation to Figures 1 and 2. A possible relationship between Vpp and the threshold voltage generated as a result of Vpp, is shown in Table I. Clearly, the greater Vpp the greater the threshold voltage Vth.

Table I

| Incoming Bit Set | Vpp (V) | Vth (V) |
|---|---|---|
| 00 | 0 | 0 |
| 01 | 15 | 3 |
| 10 | 16 | 4 |
| 11 | 17 | 5 |

5

In a non-volatile memory, the threshold voltage Vth remains unchanged as long as no new entry is supplied to the memory cell. Thus, according to the invention, the application to the single memory cell 10 of an analog control signal Vpp which is representative of the digital two-bit, or more generally, the n-bit set to store, causes the indirect storage of said set of n bits into the single memory element, in the form of a corresponding analog threshold voltage Vth.

Having stored the two-bit data set in memory cell 10, it remains there to be read and is only removed when the storage element is erased.

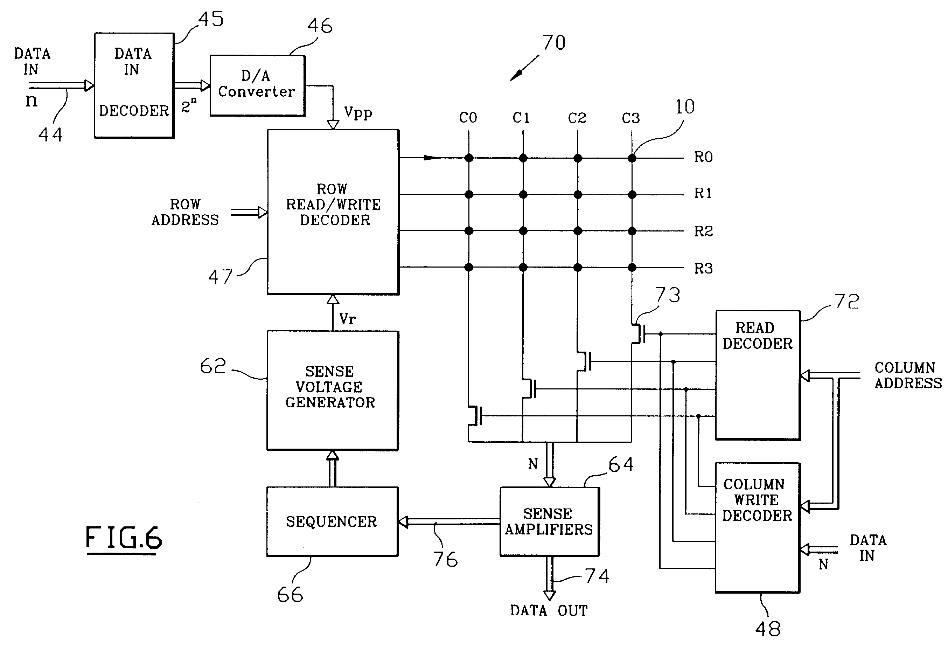

Figure 5 is a block diagram showing reading means 60 necessary for reading an n-bit data set from a single storage cell 10, acording to the invention. For reading purposes, the storage device still includes the same elementary memory cell 10 as previously in which n bits of data are stored in the form of a corresponding threshold voltage Vth, as explained above.

The reading means 60 includes a sense voltage generator 62 which applies a reading voltage Vr to the read control terminal of the memory or storage cell 10. The reading voltage is initially a value between 3 and 4 Volts, for instance 3,5V in order to discriminate between the first bit of the 2-bit set of being a "1" or a "0" (Table I). The memory cell 10 is connected to detector means implemented in the form of a sense amplifier SA 64, having two latched outputs SA1 and SA2 if the data to read are coded over 2 bits, or n outputs SA1, SA2,..., SAn in the general case (as shown by dotted line). Further, the outputs of the detector means 64 are connected to the input of a voltage sequencer 66, the output of which is supplied to sense voltage generator 62.

The operation of the above described reading means 60 is as follows.

If the memory cell 10 is conductive and allows current to pass to the first sense amplifier output SA1, the threshold voltage in cell 10 must be less than 3.5V, which is the first value of the reading voltage Vr. In other words referring to Table I, the 2 bit set must be either "10" or "11". A logic "1" is latched to the ouput SA1 of the sense amplifier 64 as a result of the detected current. If the memory cell 10 is non conductive, i.e. there is no current detected, the threshold voltage must be greater than 3.5V, thus from Table I, the 2 bit set must be either 00 or 01, and a logic 1 is latched at SA1. The logic state of output SA1 is fed back to sequencer 66 which then alters the value of the reading voltage Vr to allow the identification of the second bit of the stored 2-bit data set. If there are n bits stored in elementary memory cell 10, the same process in redone with as many reading voltages as necessary to determine the n bits.

In the 2-bit case for example, if the logic state of SA1 is "1" (i.e. the threshold voltage of the memory cell is less than 3.5V and the two-bit set is "10" or "11"), then the sense voltage is changed to 2V for example, which is between 0 and 3 Volts. The output current of cell 10 is detected by sense amplifier 64. If the sense amplifier detects a current, then the threshold voltage of the memory cell 10 must be less than the reading voltage (i.e. Vth<2V). By referring to Table I, the 2-bit set is identified as "11". The current generates a logic "1" at output SA2 of the sense amplifier. If on the other hand sense amplifier 64 does not detect a current, i.e. the memory cell is non-conductive, then the threshold voltage must be greater than the reading voltage. By referring to Table I, the two-bit set is identified as "10". The logic state of output SA2 is set to logic "0" where no current is detected.

If the logic state of SA1 is "0" after the first iteration, the sequencer selects a sense voltage of 4.5V for example (intermediate between 4 and 5V), in order to determine precisely the 2-bit set stored in the cell. With this sense voltage the sense amplifier detects whether the memory cell 10 is conductive or non-conductive. If it is conductive, Vth of the element is less than Vr, the two bit set is "01" and a logic state of "1" exists at SA2. If on the other hand cell 10 is non-conductive, Vth>Vr, therefore the two-bit set is "00" and a logic "0" state is latched at SA2.

The latched logic state at the output SA1 and SA2 of the sense amplifier can be directly read in this case to identify the two-bit set stored in the memory cell 10.

The addition of further sense amplifier outputs SA3, SA4..., SAn and additional iterations will enable the storage and reading of more bits of information in a single cell. With three sense amplifier outputs a three-bit set of data could be stored in each storage cell, and so on.

In the illustration shown in Figure 5, the single memory cell 10 has a single sense amplifier 64 associated therewith. Clearly, in a memory array with a large number of elementary cells arranged in columns and rows, a plurality of sense amplifiers may exist or a single sense amplifier may be shared by the memory cells, depending on the memory architecture, as represented schematically in Figure 6.

In this Figure, a storage device 70 is represented, in which a plurality of elementary memory cells 10 are connected in an array of cells. As a matter of example, the array is formed of 16 cells arranged in 4 columns Cø to C3 and 4 rows Rø to R3, being understood that this structure is not limitative and can easily be extended to larger arrays in order to design high capacity memory chips.

According to conventional storage technology, where each cell represents one bit of information, the array would have a capacity of 4 words of 4 bits, or a total of 16 bits.

According to the invention, the same 16-cell array has a capacity of 4 words of 8 bits, or a total of 32 bits of information, if each cell contains information coded over 2 bits.

To that effect, 8-bit sets (when $N = 8$) are supplied on D/A converter Data-In bus 44 to a data-IN decoder 45, where the 8 bits of each word are partitioned into 4 groups of $n = 2$ bits. Each 2-bit group is converted by DA converter 46 into a respective analog voltage Vpp read/write, and the voltages are sequentially applied through row decoder 47 to respective cells 10 of a given row, whereby the 8 bits of information are stored in only 4 cells. The same treatment applies to all four 8-bit words, each word being stored in a row of 4 cells, and the appropriate row/column being selected by row write decoder 47 or by column write decoder 48.

In order to read an 8-bit word from the memory array, the corresponding row is selected through decoder 47, and the 2 bits stored in each memory cell 10 of said row are retrieved. To that effect, sense voltage generator 62 generates successive reading voltages Vr, under control of sequencer 66, as described in relation to Figure 5. These successive reading voltages are applied to the Row to read which is determined by Row read/write decoder 47, and, within a row, to a given cell 10, depending on the column which is being selected by read decoder 72 and transistors 73.

Accordingly, the two bits stored in the selected cell 10 are successively latched at the outputs of sense amplifiers 64, where the 8 bits corresponding to a row of four cells of the array are available on Data-Out bus 74. Sequencer 66 selects the next reading voltage based on the information provided by sense amplifiers 64 on bus 76. It is to be noted that, while the detection means have been represented as a block 64 of 8 sense amplifiers (when $N = 8$) used in parallel by a row of cells, different arrangements are possible, within the scope of the invention.

It is further to be noted that the storage capacity of the array of memory cells could be further increased, by increasing the capacity of each cell. For instance, by increasing the number of levels of Vpp to 8, four bits of information could be stored in each cell, and the storage device represented in Figure 6 could accomodate 64 bits of information ("0" or "1") instead of 16 or 32.

The above described memory cell, storage device and write/read method have the definite advantage of providing the capability of increased storage capacity and density, for a given level of semiconductor integration and photolithography equipment performance. The use of the memory cell and storage device according to the invention allows storing more than one bit of information in a single memory cell, thus enabling further expansion of storage capacities useful in storage intensive devices and applications, without increasing the size of the memory array or reducing the size of the elementary memory cells.

## Claims

1. A storage device (70) including at least one elementary memory cell (10), characterized in that it includes means (42) for writing a set of n bits of data into each said at least one elementary memory cell, and/or means (60) for reading a set of n bits of data from each said at least one elementary memory cell, with $n \geq 2$ whereby the data bit storage capacity of said storage device (70) excedes the number of elementary memory cells (10) contained in said storage device.

2. A storage device (70) according to claim 1, wherein said means (42) for writing a set of n bits of data into each said at least one elementary memory cell (10) includes digital to analog converter means (46) for converting respective sets of n-bit digital data into respective analog writing voltages Vpp, each said respective analog writing voltage Vpp being applied to a write control terminal of a respective elementary memory cell (10), and each said writing voltage Vpp being representative of a respective n-bit digital data set, whereby n bits of data are stored into each said respective elementary memory cell (10).

3. A storage device (70) according to claim 2, characterized in that it includes D/A converter Data IN decoder means (45) receiving n bits of input data, said decoder means (45) having its outputs connected to the inputs of said digital to analog converter means (46), such as to supply said inputs with 2n-bits of digital data to be converted to analog writing voltages Vpp.

4. A storage device (70) according to claim 1, wherein said means (60) for reading a stored set of n bits of data from each said at least one elementary memory cell includes :

- means (62) for generating a sequence of analog reading voltages Vr, said voltages being successively applied to a read control terminal of each said at least one elementary storage cell (10), causing a current to flow or not to flow accross each said elementary memory cell (10) depending on the value of the respective set of n bits stored in the respective elementary memory cell, and on the value of the respective analog voltage Vr applied;
- for each elementary memory cell (10), sensing means (64) connected to said elementary memory cell such as to detect, for each applied reading voltage Vr, the event of a current flowing or not flowing accross said elementary memory cell, said sensing means (64) generating n logical latched outputs ("1" or "0") depending on the result of said detection;
- sequencing means (66) for determining the order according to which said reading voltages Vr are to be applied to each elementary memory cell (10).

5. A storage device (70) according to claim 4, wherein said sensing means (64) is comprised of a latched sense amplifier having its input connected to the read output of the associated elementary memory cell (10), and n latched outputs (SA1, SA2,...SAn) which are part of an n bit output data bus (67) representative of the n bits of data previouly stored in each memory cell, whereby each sense amplifier output identifies the value ("0" or "1") of a respective bit of the set of n bits stored in the associated elementary memory cell.

6. A storage device (70) according to claim 5, characterized in that, when a current flow is detected by said sense amplifier for a respective applied reading voltage, the value of the respective bit of said data set is a logic "1", and when no current flow is detected the value of the respective bit of said data set is a logic "0".

7. A storage device (70) according to anyone of the preceding claims, wherein each said elementary memory cell (10) comprises a CMOS device having a writing/reading control gate (22) to which the writing/reading voltages are applied, a drain (12) and a source (14), the event of a current flow in the source (14) being detected by said sensing means (64), whereby the detection of a current flow in said sensing means indicates that a logical "1" is read from the elementary memory element (10), and the detection of the absence of a current flow in said sensing means indicates that a logical "0" is read from the elementary memory element.

8. A storage device (70) according to anyone of the preceding claims, wherein said elementary memory cell (10) is a non volatile memory element, in the form of a semiconductor device.

9. A storage device (70) according to anyone one of the preceding claims, wherein said elementary memory cell (10) is an EEPROM memory cell.

10. A storage device (70) according to anyone one of the preceding claims, wherein said elementary memory cell (10) is an EPROM memory cell.

11. A storage device (70) according to anyone of the preceding claims, characterized in that it includes a plurality of RxC elementary memory cells (10), arranged according to an array of R rows and C columns, where R and C are integers greater than one.

12. A storage device (70) according to anyone of the preceding claims, wherein N sense amplifiers (64) are shared by a plurality of memory cells (10).

13. A storage device (70) according to anyone of the preceding claims, in the form of an integrated circuit or a semiconductor wafer.

14. A method of storing an n-bit data set, with n ≥ 2, in an elementary memory cell (10), characterized in that it includes the steps of :
- converting said n-bit data set into an analog voltage Vpp uniquely associated with said n-bit data set;
- applying said analog voltage Vpp to said memory cell (10), thereby producing in said memory cell a lasting threshold voltage Vth which is a function of the applied analog voltage, whereby the binary information corresponding to said n-bit data set is stored in said elementary memory cell.

**15.** A method of storing an N-bit serial data set (where N > n) into a storage device (70) according to anyone of claims 1 to 13, comprising a plurality of elementary memory cells (10), characterized in that it includes the steps of :
- partitioning said N-bit data stream into a plurality of n-bit data sets;
- storing each n-bit data set into a respective one of said elementary memory cells, according to the method of claim 14.

**16.** A method of reading from an elementary memory cell (10) an n-bit data set stored therein in the form of a threshold voltage Vth indicative of said n-bit data set, characterized in that it includes the steps of :
- applying a first predetermined reading voltage (Vr1) to said elementary memory cell (10);
- detecting a detector means the presence or absence of a current flowing in response to said first reading voltage (Vr1) and thereby identifying a first bit of said n-bit data set;
- applying a second predetermined reading voltage (Vr2) to said elementary memory cell (10);
- detecting at said second detector means the presence or absence of a current flowing in response to said second reading voltage (Vr2) and thereby identifying a second bit of said n-bit data set;
- repeating the above two-step process with respective predetermined reading voltages (Vri for i = 1 to n) until all the n bits of the n-bit data set have been identified.

**17.** A method of reading an N-bit data stream (where N > n) from a storage device (70) according to anyone of claims 1 to 14, where said storage device (70) includes a plurality of elementary memory cells (10), characterized in that it includes the steps of :
- reading from each elementary memory cell (10), an n-bit data set, according to the reading method of claim 17, whereby a plurality of n-bit data sets is obtained;
- assembling an N-bit data stream, based on said plurality of n-bit data sets.

FIG.1

FIG.2

FIG.3

58

56          56'          56''

Vref

50

52

<u>FIG.4</u>

62

Sence
voltage
generator

Vr

Storage

Cell

10

60

66

Sequencer

64

SA1          SA2          SAn

n−bit
data

output
bus

<u>FIG.5</u>

74

FIG.6

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X<br>A | US-A-5 218 569 (BANKS)<br><br>* column 4, line 41 - column 12, line 51; figures 6-14 * | 1-3,7-14<br>4-6 | G11C11/56 |
| X<br><br>A | FR-A-2 246 022 (SIEMENS)<br><br>* the whole document * | 1-4,7,<br>11-14,16<br>5,6 | |
| X | EP-A-0 340 107 (SGS-THOMSON MICROELECTRONICS)<br>* the whole document * | 1,2,4,<br>7-14,16 | |
| A | PATENT ABSTRACTS OF JAPAN<br>vol. 7, no. 30 (P-173)(1175) 5 February 1983<br>& JP-A-57 181 497 (RICOH)<br>* abstract * | 4,7,11,<br>12,16 | |
| A | PATENT ABSTRACTS OF JAPAN<br>vol. 6, no. 21 (P-152)(1095) 30 October 1982<br>& JP-A-57 120 299 (SANYO)<br>* abstract * | 4,7,11,<br>12,16 | TECHNICAL FIELDS SEARCHED (Int.Cl.6)<br><br>G11C |

The present search report has been drawn up for all claims

| Place of search | Date of completion of the search | Examiner |
|---|---|---|
| THE HAGUE | 3 February 1994 | Degraeve, L |

EPO FORM 1503 03.82 (P04C01)